Europäisches Patentamt

European Patent Office

Office européen des brevets

(11) Veröffentlichungsnummer: **0 311 816**
**A1**

## (12) EUROPÄISCHE PATENTANMELDUNG

(21) Anmeldenummer: **88115346.4**

(22) Anmeldetag: **19.09.88**

(51) Int. Cl.⁴: **H01L 29/91 , H01L 29/06 , H01L 21/225 , H01L 21/265**

(30) Priorität: **15.10.87 CH 4050/87**

(43) Veröffentlichungstag der Anmeldung:
**19.04.89 Patentblatt 89/16**

(84) Benannte Vertragsstaaten:
**CH DE FR GB IT LI NL SE**

(71) Anmelder: **BBC Brown Boveri AG**
**Haselstrasse**
**CH-5401 Baden(CH)**

(72) Erfinder: **Abbas, Christian C., Dr.**
**Im Eichtal 2**
**CH-5400 Baden(CH)**
Erfinder: **Roggwiller, Peter, Dr.**
**Püntstrasse 16**
**CH-8173 Riedt-Neerach(CH)**
Erfinder: **Voboril, Jan**
**Landschreiberstrasse 2**
**CH-5415 Nussbaumen(CH)**

(54) **Halbleiterbauelement und Verfahren zu dessen Herstellung.**

(57) In einem Halbleiterbauelement wird von einer von einer Hauptfläche (2) des Halbleitersubstrats (1) her eindringenden, seitlich begrenzten hochdotierten Zone (3) und einer die hochdotierte Zone umgebende niedrigdotierte Zone ein pn-Uebergang gebildet, welche an einem Rand der hochdotierten Zone (3) an die Hauptfläche (2) des Halbleitersubstrats (1) tritt. Der Rand der hochdotierten Zone (3) wird von einer Schutzzone (6b) gebildet, deren Dotierungsdichte in einer zur Hauptfläche (2) parallelen Richtung von der hochdotierten Zone (3) gegen den pn-Uebergang hin langsam abfällt. Ein Oberflächendurchbruch des pn-Uebergangs wird dadurch verhindert, dass die Schutzzone (6b) nahe bei der hochdotieren Zone (3) eine maximale Eindringtiefe hat und dass die maximale Eindringtiefe der Schutzzone (6b) grösser ist als die Eindringtiefe der benachbarten hochdotierten Zone (3). Die Schutzzone (6b) hat eine maximale Dotierungsdichte, die $10^{15}$ cm$^{-3}$ im wesentlichen nicht überschreitet, eine Breite die vergleichbar mit einer Dicke der niedrigdotierten Zone ist und eine maximale Eindringtiefe, welche zwischen 40 $\mu$m und 80 $\mu$m liegt. Die Dotierungsdichte der Schutzzone (6b) fällt in einer zur Hauptfläche (2) parallelen Richtung entweder annähernd linear oder stufenförmig ab.

Fig.2b

Fig.1

## Halbleiterbauelement und Verfahren zu dessen Herstellung

### Technisches Gebiet

Die Erfindung betrifft ein Halbleiterbauelement mit mindestens einem innerhalb eines Halbleitersubstrats verlaufenden pn-Uebergang, welcher von einer von einer Hauptfläche des Halbleitersubstrats her eindringenden, seitlich begrenzten hochdotierten Zone und einer die hochdotierte Zone umgebende niedrig dotierte Zone gebildet wird und an einem Rand der hochdotierten Zone an die Hauptfläche des Halbleitersubstrats tritt, wobei der Rand der hochdotierten Zone von einer Schutzzone gebildet wird, deren Dotierungsdichte in einer zur Hauptfläche parallelen Richtung von der hochdotierten Zone gegen den pn-Uebergang hin langsam abfällt.

### Stand der Technik

Halbleiterbauelemente für hohe Sperrspannungen benötigen in den Bereichen, wo der sperrende pn-Uebergang an die Oberfläche des Halbleitersubstrats tritt, spezielle Massnahmen zur Gewährleistung der Sperrfähigkeit des Halbleiterbauelements. Der Grund dafür liegt darin, dass ohne solche Massnahmen der Oberflächendurchbruch schon lange vor einer durch den Volumendurchbruch begrenzten Sperrspannung erfolgt und so die Spannungsfestigkeit des Halbleiterbauelements in unhaltbarer Weise mindert.

Wie aus der Druckschrift "Methods of avoiding edge effects on semiconductor diodes", P.A. Tove, J. Phys. D: Appl. Phys, 15 (1982) ersichtlich ist, sind bis heute eine grosse Zahl verschiedenster solcher Massnahmen bekannt, die alle zum Ziel haben, die maximal auftretenden Feldstärken im Bereich, wo der sperrende pn-Uebergang an die Oberfläche tritt, möglichst stark zu reduzieren, so dass der Volumendurchbruch wenn möglich vor dem Oberflächendurchbruch stattfindet.

Die bekannten Massnahmen können grob in zwei Klassen eingeteilt werden, wobei die erste Massnahmen umfasst, welche eine äussere Gestaltung der Oberfläche (Randprofile schleifen, Gräben ätzen) vorsehen, und die zweite solche, welche allein auf einer geeigneten inneren Dotierungsstruktur bei intakter Oberfläche beruhen.

Für Halbleiterbauelemente mit feinen Strukturen oder mit integrierten MOS-Strukturen, die bei ihrer Herstellung die Anwendung der Zerteiltechnik zulassen, sind primär solche Massnahmen von Bedeutung, welche die Oberfläche des Halbleitersubstrats intakt lassen. Dazu gehören zum Beispiel Guardringe und VLD-Strukturen (VLD = Variation of Lateral Doping). Während Guardringe ihre bestimmungsgemässe; Funktion nur dann erfüllen, wenn sie sehr präzise bemessen und hergestellt worden sind, stellen VLD-Strukturen eine robuste Alternative dar.

Die Verwendung einer VLD-Struktur zur Erhöhung der Spannungsfestigkeit ist z.B. aus "Variation of lateral doping - a new concept to avoid high voltage breakdown of planar junctions", R. Stengl and U. Gösele, IEEE 195, bekannt. An einem Rand einer hochdotierten Zone wird die Dotierungsdichte in einer zu einer Hauptfläche des Halbleitersubstrats parallelen Richtung von der Dotierungsdichte der hochdotierten Zone auf diejenige einer niedrigdotierten Zone linear abgesenkt. Ein solcher sogenannter lateraler Gradient der Dotierungsdichte der VLD-Struktur wird so hergestellt, dass durch eine Maske mit Schlitzen und Lücken mit genau abgestimmten Abmessungen Do tierstoff implantiert wird und danach eine so erzeugte Prädeposition eindiffundiert wird.

Auf diese Weise lassen sich Halbleiterbauelemente realisieren, deren Sperrspannungsfestigkeit bei etwa 90 % des Volumendurchbruchs liegt. Auch wenn solche Werte für die Sperrspannungsfestigkeit im Vergleich zu anderen Anordnungen gut sind, stellen sie nicht das erstrebenswerte Optimum dar. Ein Problem stellt zudem die Herstellung einer solchen VLD-Struktur dar, da beim bekannten Verfahren von P.A. Tove schon kleine Unregelmässigkeiten in der Maske zu unerwünschten Krümmungen des pn-Uebergangs führen, die die Sperrspannungsfestigkeit des Halbleiterbauelements erniedrigen.

### Darstellung der Erfindung

Aufgabe der vorliegenden Erfindung ist es daher, ein Halbleiterbauelement zu schaffen mit mindestens einem innerhalb eines Halbleitersubstrats verlaufenden pn-Uebergang, welcher von einer von einer Hauptfläche des Halbleitersubstrats her eindringenden, seitlich begrenzten hochdotierten Zone und einer die hochdotierte Zone umgegebenden niedrigdotierten Zone gebildet wird und an einem Rand der hochdotierten Zone an die Hauptfläche des Halbleitersubstrats tritt, wobei der Rand der hochdotierten Zone von einer Schutzzone gebildet wird, deren Dotierungsdichte in einer zur Hauptfläche parallelen Richtung von der hochdotieten Zone gegen den pn-Uebergang hin langsam abfällt, welches Halbleiterbauelement eine Sperrspannungsfestigkeit hat, die allein durch den Volumendurchbruch begrenzt ist und welches einfach herzustellen ist. Weiter ist es Aufgabe der Erfindung, ein Verfharen zur Herstellung eines solchen Halbleiterbauelements anzugeben.

Die Lösung besteht erfindungsgemäss darin, dass die Schutzzone nahe bei der hochdotierten Zone eine maximale Eindringtiefe hat und dass die maximale Eindringtiefe der Schutzzone grösser ist als die Eindringtiefe der benachbarten hochdotierten Zone.

Eine bevorzugte Ausführungsform stellt die Schutzzone dar, deren Dotierungsdichte in der zur Hauptfläche parallelen Richtung annähernd linear abfällt.

Eine weitere bevorzugte Ausführungsform bezieht sich auf die Schutzzone, deren Dotierungsdichte in der zur Hauptfläche parallen Richtung stufenförmig abfällt, wobei mindestens zwei Stufen ausgebildet sind.

Dadurch dass der pn-Uebergang am Rand der hochdotierten Zone konkav ist, werden in diesem kritischen Bereich maximale Feldstärken reduziert. Wegen der grossen Eindringtiefe der Schutzzone hat der pn-Uebergang in diesem Bereich, bedingt durch den geringen Dotierungsgradienten in einer zur Hauptfläche senkrechten Richtung, eine grosse Sperrspannungsfestigkeit.

## Kurze Beschreibung der Zeichnung

Nachfolgend soll die Erfindung anhand von Ausführungsbeispielen im Zusammenhang mit der Zeichnung näher erläutert werden. Es zeigen:

Fig. 1 einen Axialschnitt durch ein Halbleiterbauelement mit einer erfindungsgemässen Schutzzone,

Fig. 2a eine Darstellung der Dotierungsdichte einer erfindungsgemässen Schutzzone mit einer linear abfallenden Dotierungsdichte,

Fig. 2b eine Ausschnitt aus einem Axialschnitt durch ein entsprechendes Halbleiterbauelement nach Fig. 2a,

Fig. 3a eine Darstellung der Dotierungsdichte einer erfindungsgemässen Schutzzone mit zwei Stufen,

Fig. 3b einen Ausschnitt aus einem Axialschnitt durch ein entsprechendes Halbleiterbauelement nach Fig. 3a,

Fig.4a-f eine Darstellung von Verfahrensschritten bei der Herstellung eines Halbleiterbauelements mit einer Schutzzone mit einer linear abfallenden Dotierungsdichte,

Fig.5a-e eine Darstellung von Verfahrensschritten zur Herstellung eines Halbleiterbauelements mit einer zweistufig dotierten Schutzzone mit Hilfe von zwei Implantationsschritten, und

Fig.6a-c eine Darstellung von Verfahrensschritten zur Herstellung eines Halbleiterbauelements mit einer zweistufig dotierten Schutzzone mit Hilfe eines einzigen Implantationsschrittes.

## Wege zur Ausführung der Erfindung

In einem ersten Ausführungsbeispiel soll ein Halbleiterbauelement mit einer keilförmig dotierten Schutzzone beschrieben werden.

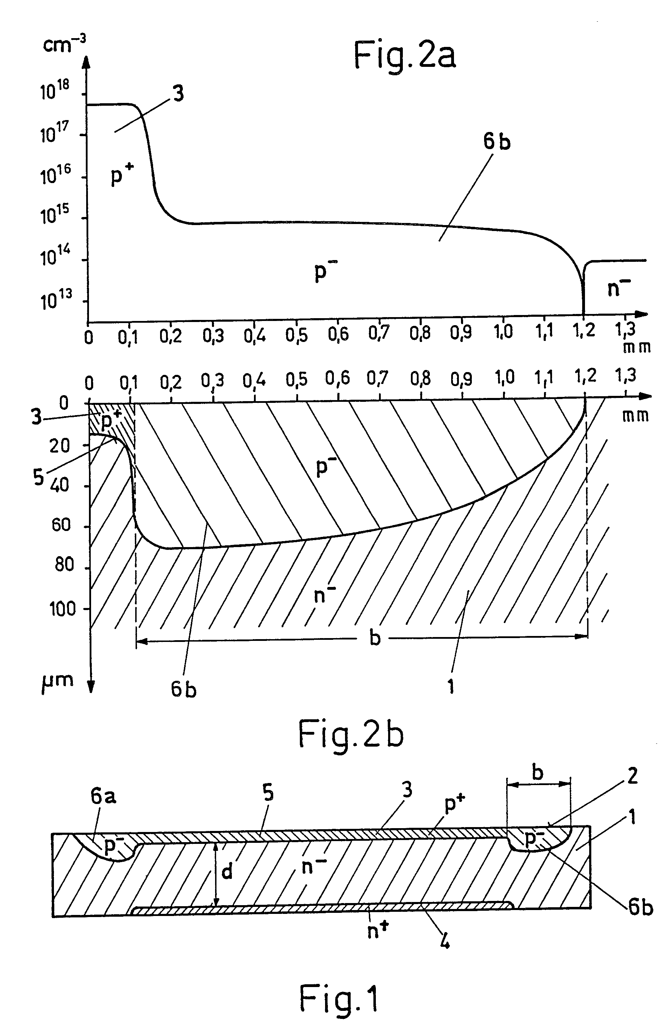

Fig. 1 zeigt einen Axialschnitt durch ein Halbleiterbauelement mit einer erfindungsgemässen Schutzzone. Um das wesentliche der Erfindung möglichst klar darstellen zu können, ist als Halbleiterbauelement eine hochsperrende Diode gewählt worden.

Ein niedrigdotiertes Halbleitersubstrat 1 hat eine Grunddotierung von etwa $7.5 \bullet 10^{13}$ cm$^{-3}$. Von einer Hauptfläche 2 des Halbleitersubstrats 1 dringt eine seitlich begrenzte, hochdotierte Zone 3 in das Halbleitersubstrats ein. Auf diese Weise wird zwischen der hochdotierten Zone 3 und dem niedrigdotierten Halbleitersubstrat 1, welches als eine niedrigdotierte Zone die hochdotierte Zone 3 umgibt, ein hochsperrender pn-Uebergang 5 gebildet.

In diesem Ausführungsbeispiel ist das Halbleitersubstrat 1 $n^-$-dotiert und die hochdotierte Zone 3 $p^+$-dotiert. Zur Kontaktierung des Halbleitersubstrats 1 ist eine Kontaktdiffusion 4 vorgesehen, welche in bekannter Weise $n^+$-dotiert ist.

Schutzzonen 6a und 6b schliessen an die hochdotierte Zone 3 an und bilden deren Rand. Sie sind $p^-$-dotiert und führen den pn-Uebergang 5 an die Hauptfläche 2.

Fig. 2b zeigt einen Ausschnitt aus Fig. 1. Auf der Abszisse ist die seitliche Ausdehnung in mm aufgetragen, wobei der Nullpunkt er Abszisse willkürlich gewählt worden ist. Auf der Ordinate ist eine Eindringtiefe in $\mu$m aufgetragen. Die Abszisse ist gleichzeitig die Hauptfläche 2 des Halbleitersubstrats 1. Die hochdotierte Zone 3 dringt etwa 15 $\mu$m tief in das Halbleitersubstrat 1 ein. Die Schutzzone 6b dringt rund 70 $\mu$m tief ein. Sie hat eine Breite b von rund 0,6 mm.

Fig. 2a zeigt eine Darstellung des Verlaufs der Dotierungsdichte entlang der Hauptfläche 2 des Halbleitersubstrats 1. Die Abszisse ist gleich gezeichnet wie in Fig. 2b. Auf der Ordinate ist die Dotierungsdichte entlang der Hauptfläche 2 des Halbleitersubstrats aufgetragen. In der hochdotierten Zone 3 liegt die Dotierungsdichte unter der Hauptfläche bei etwas weniger als $10^{18}$ cm$^{-3}$. In einem Bereich, wo die hochdotierte Zone 3 an die Schutzzone 6b grenzt, fällt die Dotierungsdichte von etwa $10^{18}$ cm$^3$ steil bis zur maximalen Dotierungsdichte der Schutzzone 6b von $10^{15}$ cm$^{-3}$ oder weniger ab. Von hier bis zu einem äusseren Ende der Schutzzone 6b, wo der pn-Uebergang 5 an die Hauptfläche 2 tritt, nimmt die Dotierungsdichte in einer zur Hauptfläche parallelen Richtung linear bis auf einen durch die Dotierungsdichte des Halbleitersubstrats 1 gegebenen Wert von etwa 7.5 $\bullet$ $10^{13}$ cm$^{-3}$ ab.

Es ist von Vorteil, die Schutzzone 6b so zu bemessen, dass ihre maximale Dotierungsdichte, welche in der Nachbarschaft der hochdotierten Zone 3 liegen soll, einen Wert von etwa $10^{15}$ cm$^{-3}$ nicht überschreitet, dass ihre Breite b etwa gleich einer Dicke d der niedrigdotierten Zone (in diesem Fall des Halbleitersubstrats 1) unterhalb der hochdotierten Zone 3 entspricht und dass ihre maximale Eindringtiefe zwischen 40 $\mu$m und 80 $\mu$m liegt.

Auf diese Weise sind folgende Vorteile gesichert:

Erstens hat der hochsperrende pn-Uebergang 5 in einem Bereich, wo die Dotierungsdichte gegen die Schutzzone hin stark abfällt, eine konkave Form. Die üblichen, hohen Feldstärken in konvexgekrümmen pn-Uebergängen können so einfach umgangen werden.

Zweitens führt der in einer zur Hauptfläche senkrechten Richtung kleine Gradient am pn-Uebergang 5 zwischen Schutzzone 6b und Halbleitersubstrat 1 zu einer erwünschten hohen Sperrspannungsfestigkeit. Dies hängt zusammen mit der gewählten, grossen Eindringtiefe der Schutzone 6b.

Drittens ist die Funktion der Schutzzone robust gegenüber kleinen Ungenauigkeiten, sowohl in Bezug auf die Dotierungsdichte als auch in Bezug auf die Eindringtiefe.

In einem zweiten Ausführungsbeispiel wird ein Halbleiterbauelement mit einer Schutzzone beschrieben, deren Dotierungsdichte in einer zur Hauptfläche parallelen Richtung stufenförmig abfällt. Das Halbleiterbauelement ist grundsätzlich wieder wie in Fig. 1 gezeigt beschaffen. Allein die Schutzzonen 6a und 6b sind wie unten erläutert ausgebildet.

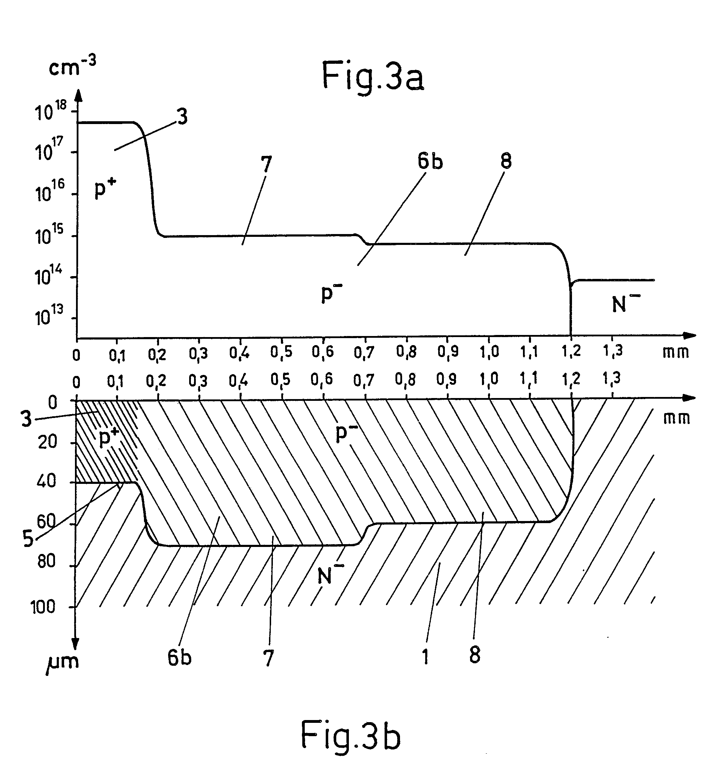

Fig. 3b zeigt einen Ausschnitt aus Fig. 1. Abszisse und Ordinate sind wie in Fig. 2b bezeichnet. Es sind die hochdotierte Zone 3, das niedrigdotierte Halbleitersubstrat 1, der pn-Uebergang 5 und die Schutzzone 6b zu erkennen. Die Schutzzone 6b zerfällt in eine erste Stufe 7, welche an die hochdotierte Zone 3 anschliesst und in eine zweite Stufe 8, welche an einem Ende der Schutzzone den pn-Uebergang an die Hauptfläche 2 führt. Die erste Stufe 7 dringt etwa doppelt so tief wie die benachbarte hochdotierten Zone 3 ein. Die zweite Stufe 8 dringt etwas weniger tief als die erste Stufe 7 ein.

Fig. 3a zeigt wiederum, analog zu Fig. 2a, eine Darstellung des Verlaufs der Dotierungsdichte entlang der Hauptfläche 2 des Halbleitersubstrats 1. Die hochdotierte Zone 3 mit einer Dotierungsdichte von etwas weniger als $10^{18}$ cm$^{-3}$ grenzt an die erste Stufe 7 der p$^-$-dotierten Schutzzone 6b, welche vorzugsweise eine Dotierungsdichte von etwa $10^{15}$ cm$^{-3}$ hat. Die zweite Stufe 8 hat vorzugsweise eine Dotierungsdichte, die etwa halb so gross wie diejenige der ersten Stufe 7 ist. die beiden Stufen sind etwa gleich breit.

Im vorliegenden Ausführungsbeispiel hat die erste Stufe 7 eine Dotierungsdichte von etwa $10^{15}$ cm$^{-3}$ und die zweite Stufe eine solche von etwa 5 $\bullet$ $10^{14}$ cm$^{-3}$. Die Eindringtiefe liegt für die erste Stufe bei etwa 70 $\mu$m und für die zweite Stufe bei etwa 60 $\mu$m. Jede Stufe ist etwa 0.5 mm breit.

Erfindungsgemäss muss die Schutzzone mindestens zwei Stufen aufweisen. Die stufenförmige Dotierungsdichte kann als eine Näherung der linear abfallenden Dotierungsdichte betrachtet werden. Demzufolge lässt sich für die Bemessung von Stufen folgende Regel aufstellen: Man wähle eine Breite der Schutzzone, teile diese in eine gewünschte Zahl von Stufen ein und setze die Dotierungsdichte der einzelnen Stufen auf einen Wert, welcher sich bei der Realisierung einer linear abfallenden Dotierungsdichte als maximaler Wert im Bereich der jeweiligen Stufe ergäbe.

Es hat sich gezeigt, dass in der Praxis zwei Stufen ausreichen, um die durch eine linear abfallende Dotierungsdichte erreichten Vorteile im wesentlichen gewährleisten zu können. Es ist experimentell bestätigt worden, dass schon bie Halbleiterbauelementen, welche eine erfindungsgemässe Schutzzone mit nur zwei Stufen aufweisen, der Volumendurchbruch wie gewünscht vor dem Oberflächendurchbruch stattfindet.

Die Erfindung hat eine grosse Zahl von Anwendungsgmöglichkeiten. Es liegt auf der Hand, in Abänderung des Ausführungsbeispiels die hochdotierte Zone 3 n$^+$-dotiert und das Halbleitersubstrat 1 p$^-$-dotiert zu wählen. Es ist auch nicht erfindungswesentlich, dass der pn-Uebergang zwischen einer hochdotierten Zone und dem Halbleitersubstrat gebildet wird. Vielmehr lässt sich die Erfindung auch auf pn-Uebergänge anwenden, welche durch zwei eindiffundierte Zonen gebildet werden. Die hochdotierte Zone 3 hat jeweils eine Dotierungsdichte von etwa $10^{17}$ - $10^{19}$ cm$^{-3}$.

Dass die Erfindung anhand einer einfachen Diode erläutert wurde, liegt mehr in einer didaktischen Ueberlegung begründet als in der bevorzugten Anwendung. Wie eingangs erwähnt, ist die Erfindung vor allem auf feinstrukturierte Halbleiterbauelemente mit hochsperrenden pn-Uebergängen wie z.B. GTO-Thyristoren oder MOS gesteuerte Thyristoren ausgerichtet. Ganz allgemein kann gesagt werden, dass, wo immer hochsperrende pn-Uebergänge an eine Hauptfläche treten, die Erfindung mit Vorteil eingesetzt werden kann.

Die vorliegende Erfindung schafft aber nicht nur Halbleiterbauelemente mit hochsperrenden pn-Uebergängen, sondern sie gibt auch Verfahren zu deren Herstellung an. Diese Verfahren sollen nachfolgend anhand der beiden oben beschriebenen Ausführungsbeispiele näher erläutert werden. Zuerst sollen Verfahren angegeben werden, welche geeignet sind, eine Schutzzone mit einer linear abfallenden Dotierungsdichte zu erzeugen.

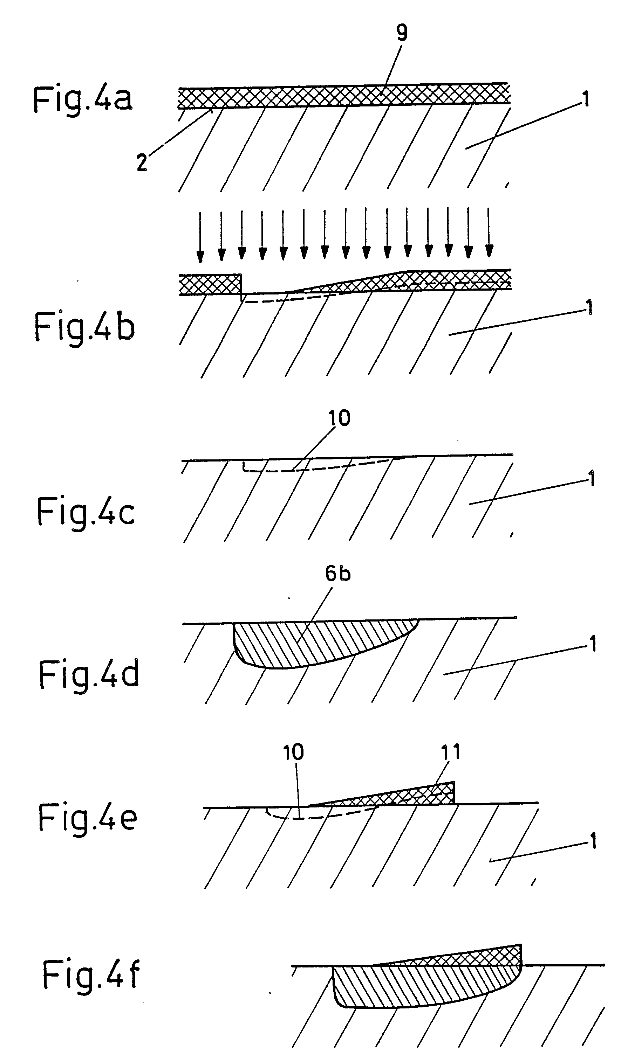

Die Fig. 4a-d zeigen die einzelnen Verfahrensschritte. Ausgangspunkt stellt ein Halbleitersubstrat 1 mit einer gewünschten Dotierung dar. Eine für die Diffusion der hochdotierten Zone 3 vorgesehene Hauptfläche 2 des Halbleitersubstrat 1 wird mit einer Maskierschicht 9 beispielsweise aus SiO₂ bedeckt. Mit einem RIE-Verfahren (RIE = Reactive Ion Etching) wie es z.B. in der Patentanmeldung CH 1091/86 offenbart wird, wird die Maskierschicht 9 dort, wo die Schutzzone vorgesehen ist, keilförmig abgeätzt. In das so maskierte Halbleitersubstrat 1 werden bei einer gegebenen Energie die gewünschten Dotierungsatome implantiert. Die Energie soll so bemessen sein, dass die keilförmige Maskierschicht 9 an ihrem stumpfen Ende ein Eindringen der Dotierungsatome in das Halbleitersubstrat verhindert (Fig. 4d).

Nach dem vollständigen Entfernen der Maskierschicht 9 liegt ein Halbleitersubstrat 1 vor, welches in einem für die Schutzzone vorgesehenen Gebiet eine langsam auslaufende Belegung 10 aufweist (Fig. 4c). In einer nachfolgenden Diffusionsbehandlung wird diese Belegung 10 in die gewünschte Tiefe eindiffundiert (4d).

In einer Abwandlung des soeben beschriebenen Verfahrens wird die keilförmige Maskierschicht 9 im Bereich der Schutzzone nicht entfernt (Fig. 4e), so dass diese keilförmige Maskierschicht 9 in der nachfolgenden Diffusionsbehandlung als eine Diffusionsquelle 11 dient (Fig. 4f).

Um ein Halbleiterbauelement mit einer Schutzzone mit einer stufenförmigen Dotierungsdichte herzustellen, kann erfindungsgemäss wie nachfolgenden beschrieben vorgegangen werden. Ziel des Verfahrens sei eine zweistufige Schutzzone, wie sie z.B. im zweiten Ausführungsbeispiel beschrieben worden ist.

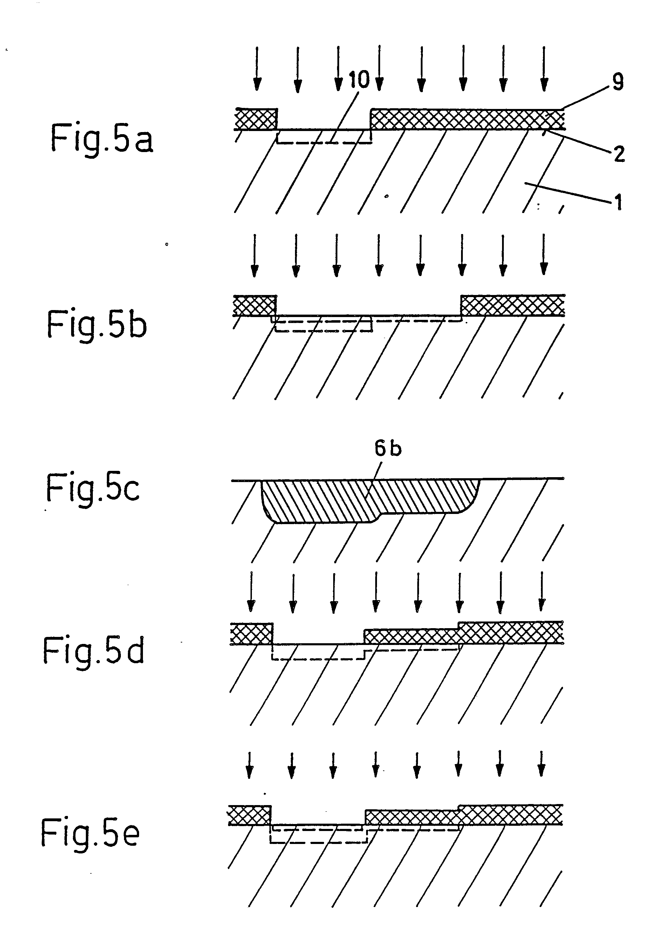

Fig. 5a bis 5c stellen die erfindungswesentlichen Verfahrensschritte dar. Eine Hauptfläche 2 eines Halbleitersubstrats 1 wird mit einer Maskierschicht 9 aus beispielsweise SiO₂ bedeckt, welche allein diejenigen Gebiete der Hauptfläche 2 freilässt, welche eine hochdotierte erste Stufe 7 der Schutzzone bilden sollen. Darauf wird ein gewünschter Dotierstoff mit einer gegebenen Energie in das Halbleitersubstrat implantiert (Fig. 5a). Die Energie ist so zu bemessen, dass die Dotierungsatome die Maskierschicht 9 nicht durchdringen können. Nun wird die Maskierschicht 9 so weit entfernt, dass die Hauptfläche 2 im ganzen Bereich der Schutzzone freiliegt. Mit einer zweiten Implantation wird die zur Erzeugung der zweiten Stufe 8 notwendige Belegung 10 erzeugt (Fig. 5b). Vor einer nachfolgenden Diffusionsbehandlung wird die Maskierschicht 9 vollständig entfernt. Fig. 5c zeigt schliesslich die fertig eindiffundierte Schutzzone 6b.

Anstatt mit zwei verschiedenen Masken kann auch mit zwei verschiedenen Energien bei den Implantationen gearbeitet werden. Die dazu erforderlichen Verfahrensschritte sind in den Fig. 5d und e dargestellt. In einem Bereich der Hauptfläche 2, welcher für die niedrigdotierte zweite Stufe 8 der Schutzzone vorgesehen ist, ist die Maskierschicht 9 etwas dünner als in den übrigen Bereichen. Die für die hochdotierte erste Stufe 7 der Schutzzone vorgesehenen Bereiche der Hauptfläche sind wieder frei von der Maskierschicht 9. Die Implantation von Dotierungsatomen erfolgt bei zwei verschiedenen Energien. Bei einer gegebenen hohen Energie vermögen die Dotierungsatome die Maskierschicht 9 im Bereich der zweiten Stufe 8 zu durchdringen und bei einer niedrigen Energie nicht. Die Maskierschicht 9 ausserhalb der für die Schutzzone vorgesehenen Bereiche ist genügend dick, so dass auch bei der hohen Energie die Dotierungsatome die Maskierschicht 9 nicht zu durchdringen vermögen. Wie im zuvor beschriebenen Verfahren wird darauf die Maskierschicht 9 vollständig entfernt und die Diffusionsbehandlung ausgeführt (Fig. 5c).

Ein drittes, bevorzugtes Verfahren zur Herstellung eines Halbleiterbauelements mit stufenförmiger Dotierungsdichte verwendet im Gebiet, wo die niedrigdotierte, zweite Stufe 8 der Schutzzone vorgesehen ist, eine Diffusionsquelle.

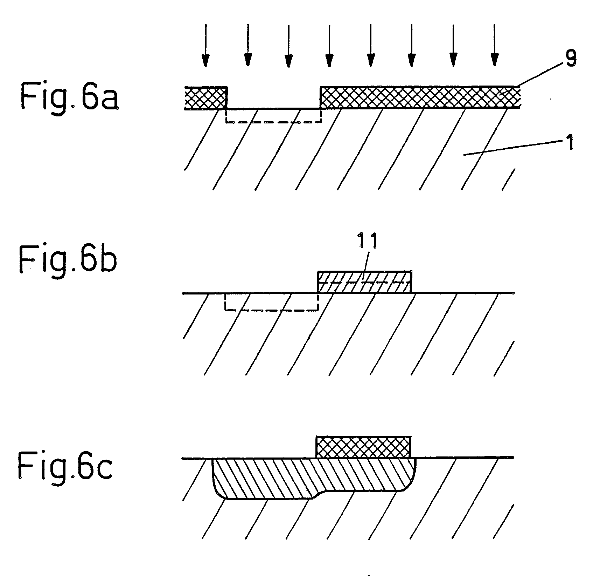

Fig. 6a-c stellen die erfindungswesentlichen Verfahrensschritte dar. Eine Hauptfläche 2 eines Halbleitersubstrats 1 wird mit einer Maskierschicht 9 bedeckt, welche allein die für die erste Stufe der Schutzzone vorgesehenen Gebiete freilässt. Die Implantation der Dotierungsatome erfolgt bei einer Energie, welche es den Dotierungsatomen nicht erlaubt, die Maskierschicht 9 zu durchdringen (Fig. 6a). Darauf wird die Maskierschicht 9 entfernt, ausser in den Gebieten, die für die niedrigdotierte, zweite Stufe 8 vorgesehen sind (Fig. 6b). In der nachfolgenden Diffusionsbehandlung wirkt dieser verbliebene Teil der Maskierschicht 9 mit den darin implantierten Dotierungsatomen als Diffusionsquelle 11. Die niedrigdotierte zweite Stufe 8 der Schutzzone wird somit durch die Diffusionsquelle 11 erzeugt (Fig. 6c).

Auch wenn nur Verfahren zur Herstellung von Halbleiterbauelementen mit zweistufig dotierten Schutzzonen näher beschrieben worden sind, heisst das nicht, dass sich nicht drei oder mehrstufig dotierte Schutzzonen in Anwendung dieser Grundidee herstellen lassen.

Die erfindungsgemässen Verfahren zur Herstellung von erfindungsgemässen Schutzzonen können als selbständige, vom jeweils zu realisierenden Halbleiterbauelement unabhängige Verfahren betrachtet werden. Sie können deshalb im Rahmen der üblichen Herstellungsschritte (z.B. Implantation, Diffusion) eingegliedert werden.

Abschliessend kann gesagt werden, dass mit der Erfindung eine wirkungsvolle Massnahme geschaffen worden ist, um Oberflächendurchbrüche bei hochsperrenden, an eine Hauptfläche eines Halbleitersubstrats tretenden pn-Uebergängen zu verhindern.

**Ansprüche**

1. Halbleiterbauelement mit mindestens einem innerhalb eines Halbleitersubstrats (1) verlaufenden pn-Uebergang (5), welcher

a) von einer von einer Hauptfläche (2) des Halbleitersubstrats (1) her eindringenden, seitlich begrenzten hochdotierten Zone (3) und einer die hochdotierte Zone (3) umgebenden niedrigdotierten Zone gebildet wird und

b) an einem Rand der hochdotierten Zone (3) an die Hauptfläche (2) des Halbleitersubstrats (1) tritt,

c) wobei der Rand der hochdotierten Zone (3) von einer Schutzzone (6a,6b) gebildet wird, deren Dotierungsdichte in einer zur Hauptfläche (2) parallelen Richtung von der hochdotierten Zone (3) gegen den pn-Uebergang (5) hin langsam abfällt, dadurch gekennzeichnet, dass

d) die Schutzzone (6a,6b) nahe bei der hochdotierten Zone (3) eine maximale Eindringtiefe hat und dass

e) die maximale Eindringtiefe der Schutzzone (6a,6b) grösser ist als die Eindringtiefe der benachbarten hochdotierten Zone (3).

2. Halbleiterbauelement nach Anspruch 1, dadurch gekennzeichnet, dass

a) die Schutzzone (61,6b) eine maximale Dotierungsdichte hat, die $10^{15}$ cm$^{-3}$ im wesentlichen nicht überschreitet,

b) dass die Schutzzone (6a,6b) eine Breite (b) hat, die vergleichbar mit einer Dicke (d) der niedrigdotierten Zone ist, und

c) dass die maximale Eindringtiefe der Schutzzone (6a,6b) nicht weniger als 40 μm und nicht mehr als 80 μm beträgt.

3. Halbleiterbauelement nach Anspruch 2, dadurch gekennzeichnet, dass die Dotierungsdichte der Schutzzone (6a,6b) in der zur Hauptfläche (2) parallelen Richtung annähernd linear abfällt.

4. Halbleiterbauelement nach Anspruch 2, dadurch gekennzeichnet, dass die Dotierungsdichte der Schutzzone (6a,6b) in der zur Hauptfläche (2) parallelen Richtung stufenförmig abfällt, wobei mindestens zwei Stufen ausgebildet sind.

5. Halbleiterbauelement nach Anspruch 4, dadurch gekennzeichnet, dass in der Schutzzone (6a,6b) genau zwei Stufen ausgebildet sind, wobei die Dotierungsdichte einer zweiten Stufe (8) etwa halb so gross wie diejenige einer zur hochdotierten Zone (3) benachbarten, ersten Stufe (7).

6. Verfahren zur Herstellung eines Halbleiterbauelements nach Anspruch 3, dadurch gekennzeichnet, dass

a) die Hauptfläche (2) des Halbleitersubstrats (1) in einem Bereich der Schutzzone (6a,6b) mit einer keilförmigen Maskierschicht (9) bedeckt wird,

b) Dotierungsatome mit einer gegebenen Energie implantiert werden, sodass die keilförmige Maskierschicht (9) an ihrem stumpfen Ende ein Eindringen der Dotiertungsatome in das Halbleitersubstrats (1) verhindert, und

b) die Maskierschicht (9) vor einer nachfolgenden Diffusionsbehandlung entfernt wird.

7. Verfahren zur Herstellung eines Halbleiterbauelements nach Anspruch 3, dadurch gekennzeichnet, dass

a) die Hauptfläche (2) des Halbleitersubstrats (1) in einem Bereich der Schutzzone (6a,6b) mit einer keilförmigen Maskierschicht (9) bedeckt wird,

b) Dotierungsatome mit einer gegebenen Energie implantiert werden, sodass die keilförmige Maskierschicht (9) an ihrem stumpfen Ende eine Eindringen der Dotierungsatome in das Halbleitersubstrat (1) verhindert, und

c) die keilförmige Maskierschicht (9) in einer nachfolgenden Diffusionsbehandlung als eine Diffusionsquelle (11) verwendet wird.

8. Verfahren zur Herstellung eines Halbleiterbauelements nach Anspruch 5, dadurch gekennzeichnet, dass

a) bei einer ersten Implantation von Dotierungsatomen die Hauptfläche (2) des Hableitersubstrats (1) in einem Bereich der zweiten Stufe (8) durch eine Maskierschicht (9) abgedeckt ist, und

b) bei einer nachfolgenden zweiten Implantation von Dotierungsatomen die Hauptfläche (2) im Bereich der ganzen Schutzzone (6a,6b) frei von einer Maskierschicht (9) ist.

9. Verfahren zur Herstellung eines Halbleiterbauelements nach Anspruch 5, dadurch gekennzeichnet, dass

a) die Hauptfläche (2) des Halbleitersubstrats (1) in einem Bereich der zweiten Stufe (8) durch eine Maskierschicht (9) bedeckt ist,

b) mit einer gegebenen hohen Energie Dotierungsatome implantiert werden, sodass auch im Bereich der zweiten Stufe (8) die Dotierungsatome durch die Maskierschicht (9) hindurch in das Halbleitersubstrat (1) eindringen und

c) mit einer gegebenen niedrigen Energie Dotierungsatome implantiert werden, sodass im Bereich der zweiten Stufe (8) die Dotierungsatome die Maskierschicht (9) nicht durchdringen.

10. Verfahren zur Herstellung eines Halbleiterbauelements nach Anspruch 5, dadurch gekennzeichnet, dass

a) bei einer Implantation von Dotierungsatomen die Hauptfläche (2) des Halbleitersubstrats (1) in einem Bereich der zweiten Stufe (8) durch einen Maskierschicht (9) abgedeckt ist und

b) die Maskierschicht (9) im Bereich der zweiten Stufe (8) bei einer nachfolgenden Diffusionsbehandlung als eine Diffusionsquelle (11) verwendet wird.

Fig.2a

Fig.2b

Fig.1

## Fig.3a

## Fig.3b

Fig.4a

Fig.4b

Fig.4c

Fig.4d

Fig.4e

Fig.4f

Fig.5a

Fig.5b

Fig.5c

Fig.5d

Fig.5e

Fig.6a

9

1

Fig.6b

11

Fig.6c

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 159 544 (SUGIMOTO) <br> * Zusammenfassung; Figuren; Seite 6, Zeile 1 - Seite 7, Zeile 6; Seite 10, Zeile 5 - Seite 11, Zeile 6; Figur 7; Seite 14, Zeile 12 - Seite 15, Zeile 27 * | 1,4,5,8 ,9 | H 01 L 29/91 <br> H 01 L 29/06 <br> H 01 L 21/225 <br> H 01 L 21/265 |
| Y | | 1,3,5,6 ,9 | |
| | --- | | |
| Y | US-A-4 638 551 (EINTHOVEN) <br> * Zusammenfassung; Figuren 1,3; Spalte 1, Zeile 65 - Spalte 2, Zeile 7; Spalte 3, Zeile 61 - Spalte 4, Zeile 11 * | 1,3,5,6 ,9 | |
| | --- | | |
| A | EP-A-0 168 771 (FÖLL) <br> * Zusammenfassung; Figuren 2,3; Seite 2, Zeile 28 - Seite 3, Zeile 8 * | 1,3,6 | |
| | --- | | |
| D,A | EP-A-0 237 844 (GOBRECHT) <br> * Spalte 3, Zeilen 7-14 * | 3,6 | |
| | --- | | RECHERCHIERTE SACHGEBIETE (Int. Cl.4) |
| A | DE-A-2 820 614 (R. BOSCH GmbH) <br> * Insgesamt * | 6,7 | H 01 L |
| | --- | | |
| A | US-A-3 607 449 (T. TAKUMA) <br> ----- | | |

Der vorliegende Recherchenbericht wurde für alle Patentansprüche erstellt

| Recherchenort | Abschlußdatum der Recherche | Prüfer |
|---|---|---|
| DEN HAAG | 17-11-1988 | MIMOUN B.J. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument